# DEMANDE DE BREVET EUROPEEN

(11) **EP 1 593 460 A1**
(43) Date de publication de la demande: **09.11.2005**
(21) Numéro de dépôt: 05290956.1
(22) Date de dépôt: 02.05.2005
(51) Int. Cl.: B24B 37/04, H01L 21/306

(54) **Procédé et élément de polissage de surface**

(30) Priorité: 07.05.2004 FR 0404946
(71) Demandeur: SOCIETE EUROPEENNE DE SYSTEMES OPTIQUES S.E.S.O., 13792 Aix-en-Provence Cedex 3 (FR)
(72) Inventeur: Fermé, Jean-Jacques, 13880 Velaux (FR)
(74) Mandataire: Jacquard, Philippe Jean-Luc

(57) **Abrégé**

Procédé de polissage de surface dans lequel une pièce (113) ayant au moins une surface à polir (115) est mise en rotation et maintenue avec ladite surface (115) en appui contre un élément de polissage (103) animé d'un mouvement de rotation ou de translation, caractérisé en ce que ladite surface (115) de la pièce (113) présente des points (P2) situés à l'extérieur d'une circonférence imaginaire (114) dont le centre coïncide avec le centre de rotation (O_{c}) de la pièce (113), et qui parcourent, au cours de la rotation de ladite pièce, une trajectoire (T_{P2}) comportant une première (T_{P2}') et une deuxième (T_{P2}") partie, le taux de polissage étant réduit sur ladite deuxième partie (T_{P2}") par rapport à ladite première partie (T_{P2}'), de manière à compenser un effet de sur-polissage du bord de ladite pièce (113) qui se produit sur la première partie (T_{P2}') de la trajectoire.

## Description

L'invention porte sur une amélioration d'un procédé de polissage de surface selon la technique CMP (polissage chimique-mécanique). Plus particulièrement, mais pas d'une manière limitative, l'invention s'applique au polissage CMP de surfaces planes de grandes dimensions (supérieures ou égales à 150 mm x 150 mm), en silice, céramique, matière vitreuse, silicium ou autre, devant présenter une planéité de l'ordre de 100 nm ou moins, telles que les surfaces des masques pour lithographie utilisées dans la production de puces électroniques.

Le polissage chimique-mécanique (CMP) est un procédé bien connu, utilisé aussi bien en optique qu'en micro-électronique. Son principe consiste à appuyer avec force la surface à polir contre un élément de polissage en mouvement par rapport à celle-ci et imbibé d'une suspension de particules abrasives (« slurry »). L'élément de polissage est typiquement un tampon en mousse de polyuréthane, ou un feutre de fibres textiles liées par une matrice de polyuréthane. La suspension de particules abrasives peut, par exemple, être de la silice colloïdale, une suspension d'oxyde de cérium ou autre.

Des informations plus détaillées sur ce procédé peuvent être trouvées dans la thèse de doctorat de Jiun-Yu Lai, « Mechanics, Mechanisms, and Modeling of the Chemical Mechanical Polishing Process », Massachusetts Institute of Technology, Février 2001.

Dans sa forme la plus courante (CMP rotatif) l'élément de polissage a une forme circulaire et est animé d'un mouvement de rotation ; un « porte-pièce » maintient en rotation la pièce à usiner, avec une de ses surfaces en contact avec l'élément de polissage. Il existe également des machines CMP linéaires, dans lesquelles l'élément de polissage est porté par une courroie fermée en boucle et animée d'un mouvement linéaire, comme dans un convoyeur à bande. Dans la suite, seul le CMP rotatif est considéré en détail, mais l'invention s'applique également au CMP linéaire.

Lorsqu'il est nécessaire de polir les deux faces d'une pièce, comme dans le cas des masques lithographiques, il est avantageux d'utiliser un procédé CMP double-face, dans lequel la pièce est prise entre deux éléments de polissage qui exercent une force de compression. Le porte-pièce doit être conçu pour permettre le contact simultané des deux faces avec les éléments de polissage.

L'expérience montre que le bord de la pièce présente un sur-polissage qui peut être très important. Cet effet est dû à l'écrasement de l'élément de polissage, qui provoque une surpression en proximité dudit bord, ainsi qu'à des accumulations de particules abrasives. Il en résulte une zone de non-planarité de la surface polie, qui peut s'étendre sur une fraction appréciable du diamètre de la pièce, par exemple de l'ordre de 15 mm pour une pièce de 150 mm de diamètre (10%). L'effet est encore plus fort dans le cas de pièces non circulaires qui présentent des angles vifs. Une discussion plus approfondie de l'effet de sur-polissage peut être trouvée dans l'article de Jianfeng Luo « Wafer-Scale CMP Modeling of With-in Wafer Non-Unifarmity », Laboratory for Manufacturing Automation, University of California, Berkeley.

Une première solution à ce problème consiste à prévoir des pièces comportant une zone périphérique à découper après le polissage. Mis à part le fait que cette technique est très coûteuse et implique un gaspillage de matériau, l'opération de découpe introduit des défauts mécaniques qui dégradent l'état de surface de la pièce. Elle n'est donc pas adaptée au cas des masques lithographiques, et plus généralement des optiques pour l'ultraviolet, qui ne peuvent pas tolérer des défauts de taille supérieure à quelques dizaines de nanomètres.

Une deuxième solution, décrite par exemple dans l'article de Jianfeng Luo cité ci-dessus, consiste à entourer la pièce par un anneau de garde, qui subit le sur-polissage à sa place. Là encore, il s'agit d'une technique coûteuse, car l'anneau doit être produit avec des tolérances très strictes et remplacé après un nombre limité d'utilisations. Cet inconvénient est encore plus marqué dans le cas du polissage double-face, où l'anneau doit avoir exactement la même épaisseur que la pièce et une seule utilisation peut l'amincir suffisamment pour rendre son remplacement nécessaire.

Un objet de la présente invention est un procédé de polissage, sur une seule face ou double-face, qui évite l'effet de sur-polissage des bords sans présenter certains des inconvénients des procédés connus de l'art antérieur.

Un autre objet de la présente invention est un élément de polissage adapté à la mise en oeuvre d'un tel procédé.

Au moins un de ces objets est atteint à l'aide d'un procédé de polissage de surface dans lequel une pièce ayant au moins une surface à polir est mise en rotation et maintenue avec ladite surface en appui contre un élément de polissage animé d'un mouvement de rotation ou de translation, caractérisé en ce que, de préférence pendant toute la durée du procédé de polissage, des points de ladite surface de la pièce situés à l'extérieur d'une circonférence de rayon donné dont le centre coïncide avec le centre de rotation de la pièce parcourent, au cours de la rotation de la pièce, une trajectoire comportant une première et une deuxième partie, le taux de polissage étant réduit sur ladite deuxième partie par rapport à ladite première partie, de manière à compenser au moins partiellement un effet de sur-polissage du bord de ladite pièce qui se produit sur la première partie de la trajectoire.

La région de la pièce située à l'extérieur de cette circonférence est une couronne ayant une largeur comprise entre 0,1% et 30%, et typiquement de l'ordre de 10%, du diamètre de ladite pièce (ou de sa dimension principale, telle que la diagonale la plus longue, dans le cas d'une pièce non circulaire).

Dans un premier mode de réalisation, la pièce à polir dépasse d'au moins un des bords de l'élément de polissage, de telle sorte que ladite deuxième partie de trajectoire s'effectue à l'extérieur dudit élément de polissage. Plus particulièrement, dans le cas d'une machine rotative, l'élément de polissage peut avoir une forme circulaire et la pièce à polir peut dépasser de son bord externe, et/ou l'élément de polissage peut présenter une ouverture délimitée par un bord interne de forme circulaire et la pièce à polir peut dépasser dudit bord interne. Dans le cas d'une machine linéaire, la pièce peut dépasser d'un bord latéral de l'élément de polissage, ou des deux.

Dans un deuxième mode de réalisation, l'élément de polissage présente au moins un bord de forme irrégulière, avec des protubérances et des échancrures, et la pièce à polir dépasse dudit bord, de moins en correspondance de certaines desdites échancrures, de telle sorte que ladite deuxième partie de trajectoire s'effectue à l'extérieur dudit élément de polissage et a une longueur qui, pour un point donné, varie d'une manière irrégulière d'une rotation de ladite pièce à une autre. Comme dans le premier mode de réalisation, dans le cas d'une machine rotative le bord peut être un bord externe et/ou un bord interne, et dans le cas d'une machine linéaire il peut s'agir d'un bord latéral ou des deux.

Dans un troisième mode de réalisation, l'élément de polissage présente une section qui est déformée dans au moins une région en proximité d'un de ses bords de manière à exercer sur la pièce à polir, en correspondance de ladite région, une pression inférieure à celle du reste de l'élément de polissage, de telle sorte que ladite deuxième partie de trajectoire s'effectue dans ladite région déformée de l'élément de polissage. Comme dans le premier et dans le deuxième mode de réalisation, dans le cas d'une machine rotative le bord peut être un bord externe et/ou un bord interne, et dans le cas d'une machine linéaire il peut s'agir d'un bord latéral ou des deux.

Avantageusement le procédé en question est du type double-face, c'est à dire que le polissage s'effectue simultanément sur deux faces opposées de la pièce à polir à l'aide de deux éléments de polissage.

La présente invention porte également sur un élément de polissage destiné à être utilisé dans un procédé tel que décrit ci-dessus, caractérisé en ce qu'il présente au moins un bord de forme irrégulière, avec des protubérances et des échancrures.

La présente invention porte également sur un élément de polissage destiné à être utilisé dans un procédé tel que décrit ci-dessus, caractérisé en ce qu'il comporte, au voisinage d'un de ses bords, au moins une zone présentant une action de polissage moindre que le reste dudit élément de polissage.

Plus particulièrement un tel élément de polissage peut avoir au moins un bord présentant une forme irrégulière, avec des protubérances et des échancrures, ledit bord étant compris entre une limite interne et une limite externe, de telle sorte que la zone délimitée par lesdites limites interne et externe présente une action « moyenne » de polissage moindre que le reste dudit élément de polissage.

Alternativement, un tel élément de polissage peut avoir une région périphérique qui présente une section déformée de manière à exercer sur la pièce à polir une pression inférieure à celle du reste de l'élément de polissage.

D'autres caractéristiques, détails et avantages de l'invention ressortiront à la lecture de la description faite en référence aux dessins annexés, donnés à titre d'exemple et dans lesquels :
- les figures 1 A et 1 B montrent respectivement une vue latérale et en plan d'une machine CMP rotative connue de l'art antérieur ;
- les figures 2A et 2B montrent des vues en plan d'une machine CMP rotative illustrant deux variantes d'un premier mode de réalisation d'un procédé selon l'invention ;
- la figure 3, qui est également une vue en plan, illustre un deuxième mode de réalisation ;
- la figure 4 montre une vue latérale d'une machine CMP rotative, illustrant un troisième mode de réalisation ; et
- la figure 5 permet d'apprécier l'effet de sur-polissage des bords obtenu avec une machine CMP connue de l'art antérieur et sa réduction par la mise en oeuvre de l'invention.

La figure 1A montre une vue latérale d'une machine CMP rotative 100, constituée par un plateau 101 tournant avec une vitesse angulaire ωₚ et portant, sur sa surface supérieure, un élément de polissage 103. En position excentrée par rapport au plateau se trouve un porte-pièce 110, tournant avec une vitesse angulaire ω_{c}, qui maintient une pièce 113 ayant une face à polir 115 de manière à forcer ladite face 115 contre l'élément de polissage 103 avec une pression F, typiquement comprise entre 1 et 300 g/cm² . La suspension de particules abrasives 120 tombe sur un point excentré de l'élément de polissage 103 et est repartie de manière uniforme sur toute sa surface par effet centrifuge.

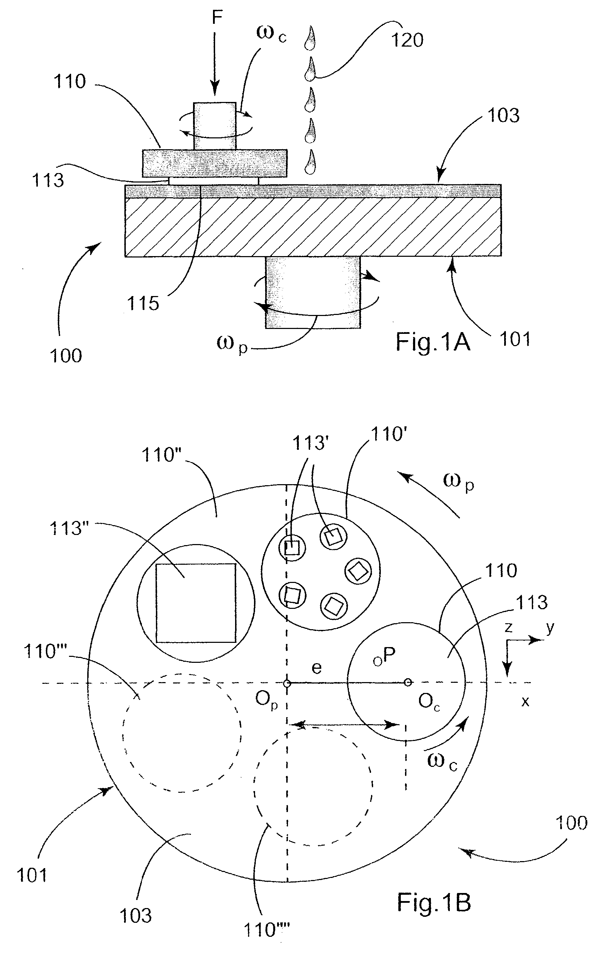

La figure 1 B montre une vue en plan de la même machine CMP, sur le plateau de laquelle sont placés plusieurs porte-pièces 110, 110' ; 110", 110"'et 110"". Le porte-pièce 110 maintient une seule pièce circulaire, le porte-pièce 110', une pluralité de petites pièces 113'de formes différentes, ; le porte-pièce 110" une seule pièce 113", de forme rectangulaire.

On considère normalement que le taux d'érosion Tₑ en un point P de la surface à polir est proportionnel à la pression F et à la vitesse relative V entre le point P et l'élément de polissage 103 : c'est l'équation de Preston, qui s'écrit Tₑ=K_{P}·V·F, où K_{P} (coefficient de Preston) est un paramètre empirique qui, pour une surface à polir donnée, dépend des caractéristiques de l'élément de polissage 103 et de la suspension de particules abrasives 120.

Un simple calcul de cinématique montre que, si ω_{c}=ωₚ, la vitesse V est indépendante de la position du point P et proportionnelle uniquement au produit entre ωₚ et la distance e entre le centre de rotation Oₚ du plateau 101 et le centre de rotation O_{c} du porte-pièce 110. En principe, ces conditions devraient permettre une uniformité optimale du polissage, mais des considérations techniques conduisent parfois à s'en écarter délibérément, notamment pour moyenner les effets d'éventuelles inhomogénéités de l'élément de polissage. En effet, le simple modèle cinématique décrit ci-dessus ne prétend pas de fournir une description complète du procédé CMP : en particulier, il ne prend pas en compte les phénomènes d'écrasement de l'élément de polissage et de répartition non-uniforme de la suspension abrasive qui sont responsables du problème de sur-polissage des bords de la pièce, résolu par la présente invention.

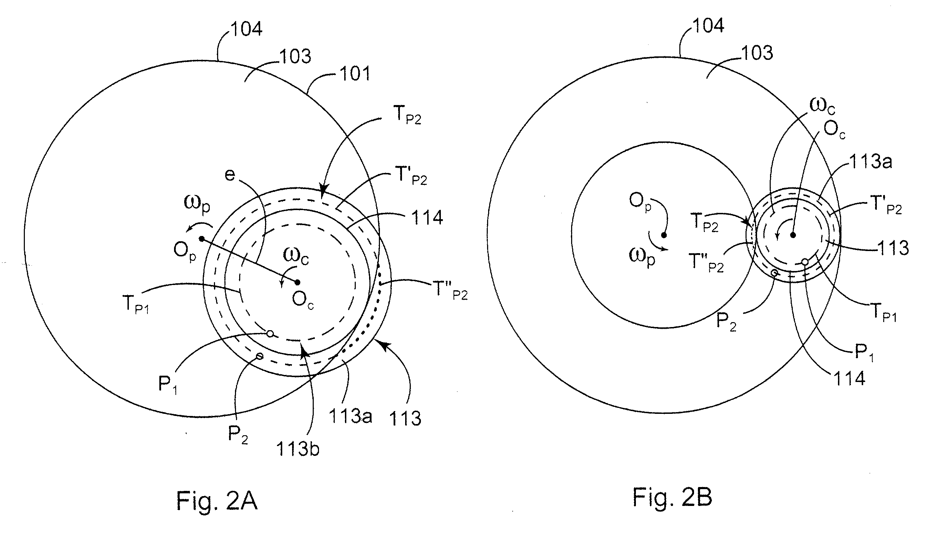

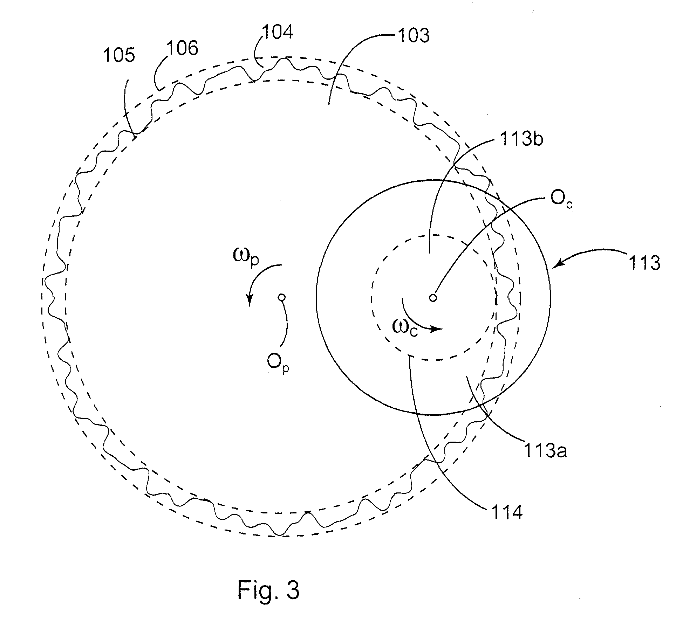

La figure 2A est une vue en plan d'une machine CMP rotative comme celle des figures 1A et 1B, dans laquelle l'élément de polissage 103 a une forme circulaire et un diamètre tel que la pièce à polir 113, elle aussi de forme circulaire et dont le centre coïncide avec le centre de rotation O_{c} du porte-pièce, dépasse de son bord externe 104 d'une fraction de son diamètre comprise entre 0,1% et 30%, typiquement de l'ordre de 10%. Alternativement, le centre de la pièce peut être décalé volontairement du centre de rotation du porte pièce. Sur la figure, une ligne imaginaire 114 trace la frontière entre une zone externe 113a en forme de couronne circulaire, constituée par les points qui, au cours de la rotation de la pièce 113, sont amenés à dépasser de l'élément de polissage, et une zone interne 113b. Il faut considérer que dans les figures 2A, 2B et 3, la largeur de la zone 113a est fortement exagérée pour des raisons de clarté.

Un point P1 situé dans la zone 113b parcourt une trajectoire circulaire T_{P1} entièrement à l'intérieur de l'élément de polissage 103 ; si le régime de fonctionnement de la machine est tel que ω_{c}=ωₚ, le taux d'érosion en correspondance du point P1, déterminé par l'équation de Preston, est sensiblement constant sur toute sa trajectoire. La condition ω_{c}=ωₚ est mentionnée à titre d'exemple uniquement et n'est pas essentielle. Typiquement, 0,1 ≤ |ω_{c}/ωₚ| ≤ 10, et de préférence 0,5 ≤ |ω_{c}/ωₚ| ≤ 2, les vitesses angulaires ω_{c} et ωₚ étant généralement comprises entre 1 et 60 tours par minute et pouvant être de signe opposé.

Un point P2 situé dans la zone 113a, au contraire, parcourt une trajectoire circulaire T_{P2} qui se compose d'une première partie T'_{P2} interne à l'élément de polissage 103, sur laquelle le taux d'érosion est supérieur à celui du point P1 à cause dudit effet de sur-polissage, et d'une deuxième partie T"_{P2} externe à l'élément de polissage 103, sur laquelle le taux d'érosion est nul. Plus le point P2 est proche du bord externe de la pièce 113, plus cette deuxième partie T"_{P2} de sa trajectoire est longue.

Le principe de l'invention est de compenser le sur-polissage subi par la surface de la pièce 113 au voisinage du bord de la pièce sur la première partie T'_{P2} interne de sa trajectoire par l'absence de polissage qui caractérise la deuxième partie T"_{P2} de cette même trajectoire. Idéalement on voudrait que, après un tour complet de la pièce 113, l'érosion soit la même pour le point P1 et le point P2, quelle que soit la position de ce dernier à l'intérieur de la zone 113a. En général, il n'est pas possible d'atteindre pleinement cet objectif, mais on choisit expérimentalement, et/ou à l'aide d'un modèle numérique, des conditions de travail qui permettent de s'en rapprocher le plus possible. Typiquement, il est difficile de modifier la distance e entre le centre de rotation Oₚ du plateau 101 et le centre de rotation O_{c} du porte-pièce, car il s'agit d'une caractéristique propre à la machine CMP utilisée. On préfère donc faire varier le diamètre de l'élément de polissage jusqu'à atteindre une valeur optimale du dépassement de la pièce 113.

En variante, comme illustré sur la figure 2B, l'élément de polissage 103 peut avoir une forme de couronne circulaire et la pièce 113 peut dépasser de son bord interne, ou aussi bien du bord externe 104 que du bord interne (non représenté).

Dans certains cas, ce premier mode de réalisation d'un procédé selon l'invention ne donne pas des résultats satisfaisants, car en raison de la transition entre les zones 113a et 113b une discontinuité en forme de marche est susceptible d'apparaître le long de la ligne 114.

Un deuxième mode de réalisation d'un procédé selon l'invention, illustré par la figure 3, permet de pallier cet inconvénient grâce à l'utilisation d'un bord externe 104 et/ou d'une découpe interne (non représentée) non circulaire, ayant de préférence une forme irrégulière avec des protubérances et des échancrures. Le bord 104 de l'élément de polissage est, dans ce cas, compris entre une circonférence interne 105 et une circonférence externe 106. La zone 113a redéfinie ici comme étant constituée par les points de la pièce 113 qui, au cours de la rotation de ladite pièce, sont amenés à dépasser de la circonférence interne 105. Comme dans le cas du premier mode de réalisation, la largeur de la zone 113a est généralement comprise entre 0,1% et 30% du diamètre ou de la dimension principale de la pièce 113, et est typiquement de l'ordre de 10%. La longueur de la deuxième partie T"_{P2} de la trajectoire d'un point P2 appartenant à la zone 113a est comprise entre une valeur maximale, qui est celle qui correspondrait à un élément de polissage ayant un bord externe coïncidant avec la circonférence interne 105, et une valeur minimale, qui est celle qui correspondrait à un élément de polissage ayant un bord externe coïncidant avec la circonférence externe 106 et qui est zéro pour les points qui ne peuvent pas déborder de ladite circonférence externe 106. Si les vitesses angulaires ω_{c} et ωₚ différent, même de peu, cette longueur varie d'une manière irrégulière d'un tour de la pièce 113 à l'autre. Il en résulte un effet de moyenne qui prévient l'apparition de la discontinuité en forme de marche susceptible d'apparaître avec une mise en oeuvre du premier mode de réalisation d'un procédé selon l'invention. Le rapport entre ω_{c} et ωₚ est généralement compris entre 0,1 et 10, et de préférence entre 0,5 et 2 en valeur absolue, mais il n'est pas égal à 1, afin de permettre ledit effet de moyenne.

On a considéré ici le cas où la pièce 113 dépasse du bord externe 104 de l'élément de polissage 103, mais, comme pour le premier mode de réalisation, on peut également se servir d'une découpe interne.

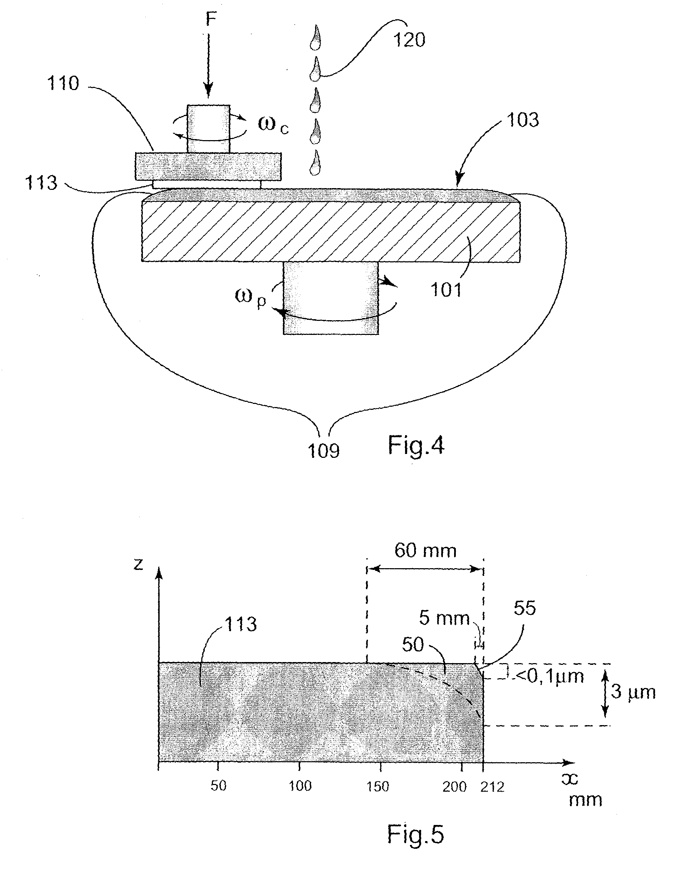

Dans un troisième mode de réalisation, illustré par la figure 4, la partie périphérique 109 de l'élément de polissage 103 est déformée dans sa section radiale de manière à exercer sur la pièce 113 une pression réduite par rapport à sa partie centrale (la déformation de l'élément de polissage est fortement exagérée sur la figure 4 dans un souci de clarté). Cette déformation peut être, par exemple, un amincissement de l'élément de polissage par usure sélective (« rodage »), ou bien une déformation du plateau rigide 101 obtenue en déformant légèrement sa partie périphérique en direction opposée à la pièce 113. L'amincissement ou la déformation sont effectués sur une zone périphérique de l'élément de polissage 103 ou du plateau rigide 101 dont la largeur est généralement comprise entre 0, 1 % et 30% du diamètre ou de la dimension principale de la pièce 113, et est typiquement de l'ordre de 10%. L'amplitude dudit amincissement ou déformation est comprise entre quelques microns et quelques centaines de microns, de préférence entre quelques microns et quelques dizaines de microns.

Le principe est sensiblement le même que dans les deux premiers modes de réalisation de l'invention : le sur-polissage est compensé par le fait que les points près du bord de la pièce 113 effectuent une partie de leur trajectoire sur une partie 109 de l'élément de polissage 103 qui produit une érosion réduite. La mise en oeuvre est plus complexe, particulièrement par rapport au premier mode de réalisation, mais l'optimisation du procédé peut être effectuée de manière plus fine.

Le procédé d'optimisation peut consister, par exemple, à partir d'un élément de polissage non déformé et à réaliser des essais avec une déformation croissante.

Comme dans les autres modes de réalisation de l'invention les vitesses angulaires ω_{c} et ωₚ sont généralement comprises entre 1 et 60 tours par minute et leur rapport en valeur absolue est compris entre 0,1 et 10, et de préférence entre 0,5 et 2.

Eventuellement, une partie de la pièce peut dépasser du bord 104 de l'élément de polissage, comme dans le premier mode de réalisation. Il est également possible de combiner les différents modes de réalisation : on peut imaginer un élément de polissage en forme de couronne circulaire, comme celui de la figure 2B, présentant des bords irréguliers, comme sur la figure 3, et une déformation comme celle du troisième mode de réalisation en proximité des bords interne et externe.

La figure 5 (non à l'échelle) montre une vue en coupe de la région périphérique d'une pièce 113 polie par un procédé selon l'invention (trait plein) et par un procédé CMP conventionnel (trait hachuré). La coupe est effectuée le long de la diagonale d'une pièce carrée de 300x300 mm. Dans le cas où un procédé conventionnel a été utilisé, on peut observer un effet de sur-polissage qui peut atteindre 3 µm de diminution d'épaisseur sur une région 50 d'une largeur d'environ 60 mm. Dans le cas d'un procédé selon l'invention, au contraire, la diminution d'épaisseur de la pièce en correspondance du bord est inférieure à 0,1 µm et est limitée à une région 55 ayant une largeur de seulement 5 mm environ.

Trois modes de réalisation de l'invention ont été décrits en référence à une machine CMP rotative à une seule face. Il est cependant entendu que l'invention s'applique également aux cas de machines CMP linéaires et des machines double-face, indifféremment linéaires ou rotatives. Comme mentionné dans l'introduction, ce dernier cas est même celui pour lequel son utilisation est plus avantageuse.

Dans le cas du polissage double-face de plusieurs pièces 113' portées par un même porte-pièces 110' (voir figure 1B), il faudra veiller à que les pièces puissent tourner individuellement autour de leur propre centre, indépendamment du porte-pièce, afin que l'effet de compensation du sur-polissage se produise partout.

## Revendications

1. Procédé de polissage de surface dans lequel au moins une pièce (113) ayant au moins une surface à polir (115) est mise en rotation et maintenue avec ladite surface (115) en appui contre un élément de polissage (103) animé d'un mouvement de rotation ou de translation, **caractérisé en ce que**, pendant toute la durée du procédé de polissage, des points (P2) de ladite surface (115) de la pièce (113) situés à l'extérieur d'une circonférence de rayon donné (114) dont le centre coïncide avec le centre de rotation de la pièce (113) parcourent, au cours de la rotation de ladite pièce, une trajectoire (T_{P2}) comportant une première (T_{P2}') et une deuxième (T_{P2}") partie, le taux de polissage étant réduit sur ladite deuxième partie (T_{P2}") par rapport à ladite première partie (T_{P2}'), de manière à compenser au moins partiellement un effet de sur-polissage du bord de ladite pièce (113) qui se produit sur la première partie (T_{P2}') de la trajectoire, dans lequel la région (113a) de la pièce (113) située à l'extérieur de ladite circonférence (114) et a une largeur comprise entre 0,1% et 30%, et de préférence de l'ordre de 10%, du diamètre ou de la dimension principale de ladite pièce (113).

2. Procédé selon la revendication 1, dans lequel le rapport entre la vitesse de rotation (ω_{c}) de la pièce (113) et celle (ωₚ) de l'élément de polissage (103) est compris entre 0,1 et 10 en valeur absolue.

3. Procédé selon la revendication 1, dans lequel le rapport entre la vitesse de rotation (ω_{c}) de la pièce (113) et celle (ωₚ) de l'élément de polissage (103) est compris entre 0,5 et 2 en valeur absolue.

4. Procédé selon l'une des revendications précédentes, dans lequel la pièce à polir (113) dépasse d'au moins un des bords (104) de l'élément de polissage (103), de telle sorte que ladite deuxième partie (T_{P2}") de trajectoire s'effectue à l'extérieur dudit élément de polissage (103).

5. Procédé selon la revendication 4, dans lequel l'élément de polissage (103) a une forme circulaire et la pièce à polir (113) dépasse de son bord externe (104).

6. Procédé selon la revendication 4 ou 5, dans lequel l'élément de polissage (103) présente une ouverture délimitée par un bord interne de forme circulaire et la pièce à polir (113) dépasse dudit bord interne.

7. Procédé selon l'une des revendications précédentes, dans lequel l'élément de polissage (103) présente au moins un bord de forme irrégulière (104), avec des protubérances et des échancrures, et la pièce à polir (113) dépasse dudit bord (104), de moins en correspondance de certaines desdites échancrures, et dans lequel l'élément de polissage (103) est animé par un mouvement de rotation avec une vitesse angulaire (ωₚ) différente de celle (ω_{c}) de la pièce (113), de telle sorte que ladite deuxième partie (T_{P2}") de trajectoire s'effectue à l'extérieur dudit élément de polissage (103) et a une longueur qui, pour un point (P2) donné, varie d'une manière irrégulière d'une rotation de ladite pièce (113) à une autre.

8. Procédé selon l'une des revendications 1 à 6, dans lequel l'élément de polissage (103) présente au moins un bord de forme irrégulière (104), avec des protubérances et des échancrures, et la pièce à polir (113) dépasse dudit bord (104), de moins en correspondance de certaines desdites échancrures, et dans lequel l'élément de polissage (103) est animé par un mouvement translation, de telle sorte que ladite deuxième partie (T_{P2}") de trajectoire s'effectue à l'extérieur dudit élément de polissage (103) et a une longueur qui, pour un point (P2) donné, varie d'une manière irrégulière d'une rotation de ladite pièce (113) à une autre.

9. Procédé selon l'une des revendications précédentes, dans lequel l'élément de polissage (113) présente une section qui est déformée dans au moins une région (109) en proximité d'un de ses bords (104) de manière à exercer sur la pièce à polir (113), en correspondance de ladite région (109), une pression inférieure à celle du reste de l'élément de polissage, de telle sorte que ladite deuxième partie (T_{P2}") de trajectoire s'effectue dans ladite région déformée (109) de l'élément de polissage (103).

10. Procédé selon l'une des revendications précédentes, dans lequel le polissage s'effectue simultanément sur deux faces opposées de la pièce à polir, à l'aide de deux éléments de polissage.

11. Élément de polissage (103) destiné à être utilisé dans un procédé selon l'une des revendications précédentes, **caractérisé en ce qu'**il comporte, au voisinage d'un de ses bords (104), au moins une zone présentant une action de polissage moindre que le reste dudit élément de polissage.

12. Elément de polissage (103) selon la revendication 11, dont au moins un bord (104) a une forme irrégulière, avec des protubérances et des échancrures, ledit bord étant compris entre une limite interne (105) et une limite externe (106), de telle sorte que la zone délimitée par lesdites limites interne (105) et externe (106) présente une action moyenne de polissage moindre que le reste dudit élément de polissage.

13. Elément de polissage (103) selon la revendication 11, dans lequel ladite zone présentant une action de polissage moindre que le reste dudit élément de polissage est une région périphérique (109) qui présente une section déformée de manière à exercer sur la pièce à polir (113) une pression inférieure à celle du reste de l'élément de polissage.
